# EUROPEAN PATENT SPECIFICATION

(11) **EP 0 887 710 B1**
(45) Date of publication and mention of the grant of the patent: **19.02.2003**
(21) Application number: 98109959.1
(22) Date of filing: 02.06.1998
(51) Int. Cl.: G03F 7/30

(54) **Resist development process**
Resistentwicklungsverfahren
Procédé de développement de photoréserves

(30) Priority: 26.06.1997 US 883116
(43) Date of publication of application: 30.12.1998
(73) Proprietor: Infineon Technologies AG, 81669 München (DE)
(72) Inventor: Lu, Zhijian, Poughkeepsie, NY 12603 (US)
(74) Representative: Patentanwälte Westphal, Mussgnug & Partner

(56) References cited:
- EP-A- 0 321 281
- EP-A- 0 794 463
- US-A- 4 655 162
- US-A- 5 416 047
- PATENT ABSTRACTS OF JAPAN vol. 97, no. 4, 30 April 1997 & JP 08 321464 A (TOKYO ELECTRON LTD.), 3 December 1996
- DATABASE WPI Section PQ, Week 9529 Derwent Publications Ltd., London, GB; Class P84, AN 95-221644 XP002107798 & JP 07 135136 A (FUJITSU LTD.) , 23 May 1995
- DATABASE WPI Section PQ, Week 9733 Derwent Publications Ltd., London, GB; Class P84, AN 97-360502 XP002107799 & JP 09 152720 A (DAINIPPON SCREEN SEIZO KK), 10 June 1997
- DATABASE WPI Section PQ, Week 9618 Derwent Publications Ltd., London, GB; Class P84, AN 96177612 XP002107800 & JP 08 055781 A (NIPPON STEEL CORP.) , 27 February 1996
- PATENT ABSTRACTS OF JAPAN vol. 15, no. 434 (E-1129), 6 November 1991 & JP 03 181118 A (TOSHIBA CORP.), 7 August 1991
- PATENT ABSTRACTS OF JAPAN vol. 96, no. 9, 30 September 1996 & JP 08 138990 A (FUROTETSUKU KK), 31 May 1996
- PATENT ABSTRACTS OF JAPAN vol. 16, no. 225 (E-1214), 10 June 1992 & JP 04 056121 A (NIPPONDENSO CO. LTD.), 24 February 1992
- PATENT ABSTRACTS OF JAPAN vol. 17, no. 514 (E-1433), 16 September 1993 & JP 05 136046 A (OKI ELECTRIC IND. CO. LTD.), 1 June 1993

## Description

### 1. Technical Field

Processes for developing resist patterns are described herein. More specifically, novel upside-down, spin development processes are described.

### 2. Background of Related Art

Photolithographic processes for the development of photo masks and conductive patterns on wafers are known in the semiconductor industry. Generally, a resist coating is applied to a substrate and is subjected to a pattern making process, e.g., selective exposure to electromagnetic rays such as ultraviolet rays or drawing with a beam of particles such as electrons. The resist coating or film is then developed by contacting the coating with a chemical developing liquid. Several resist development processes are known in the semiconductor industry.

For example, U.S. Patent No. 5,194,350 discloses a process for developing a resist layer by immersing a workpiece having a resist layer into a bath of developer. During development, the developer is withdrawn from the vessel and an additional amount of developer is introduced into the vessel. This immersion development process is slow, consumes relatively large amounts of developer and is imprecise due to changes in developer conditions.

As another example, US-A-5,416,047, US-A-4, 647, 172, JP-A-8321464 or EP-A-0794463 disclose methods for developing microlithographic resists by spinning a chuck that holds a wafer and dripping or spraying the upper surface of the wafer with a developer solution. Although spinning drip or spray developments are quick processes that can be easily automated, they provide poor developing uniformity.

As yet another example, Patent No. 5,342,738 discloses a method for developing a resist film by applying a puddle of developer onto the surface of the resist film. However, as the developing process progresses, concentration gradients are produced within the static puddle resulting in poor control of the developing process.

Furthermore, EP-A-0321281 discloses a process where a wafer has to submerge different baths in order to develop resist patterns. While this process provides good uniformity in developing, the transfer of the wafers from one bath to another is quite complicated.

It would be desirable to provide a resist development process that is easily implemented and provides good uniformity in developing.

### SUMMARY OF THE INVENTION

Novel processes for developing a resist layer have been discovered which include the steps of applying a resist coating to at least a portion of a surface of a substrate; developing the resist coating by contacting the resist layer with developer and rotating the substrate while the resist layer is in contact with the developer as it is described in the claims.

The method according to the invention is defined in claim 1.

The apparatus according to the invention is defined in claim 17.

### BRIEF DESCRIPTION OF THE DRAWINGS

A preferred embodiment of spin development process and of an apparatus for performing the process are described below with reference to the drawings wherein:
FIG. 1 is a schematic view illustrating an apparatus suitable for performing a development process according to the present disclosure;
FIG. 2 is a schematic view of the apparatus of FIG. 1 showing the step of moving the resist layer into contact with developer contained with the vessel;
FIG. 3 is a schematic view of the apparatus of FIG. 1 showing the step of rotating the substrate while the resist layer is in contact with the developer;
FIG. 4 is a schematic view of the apparatus of FIG. 1 showing the steps of moving the resist layer out of contact with the developer and draining the developer from the vessel;
FIG. 5 is a schematic view of the apparatus of FIG. 1 showing the steps of adding rinsing fluid to the vessel and contacting the resist layer with the developer;
FIG. 6 is a schematic view of the apparatus of FIG. 1 showing the step of rotating the substrate while the resist layer is in contact with the rinsing fluid; and

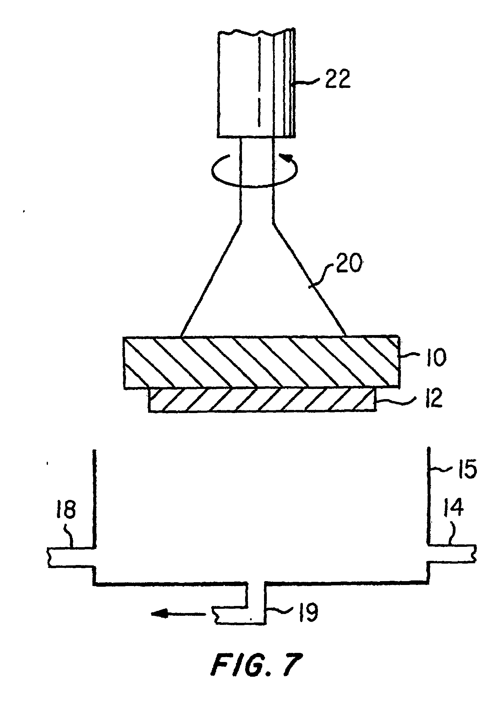

FIG. 7 is a schematic view of the apparatus of FIG. 1 showing the steps of spinning the substrate to remove rinsing fluid and draining rinsing fluid from the vessel.

### DESCRIPTION OF THE PREFERRED EMBODIMENTS

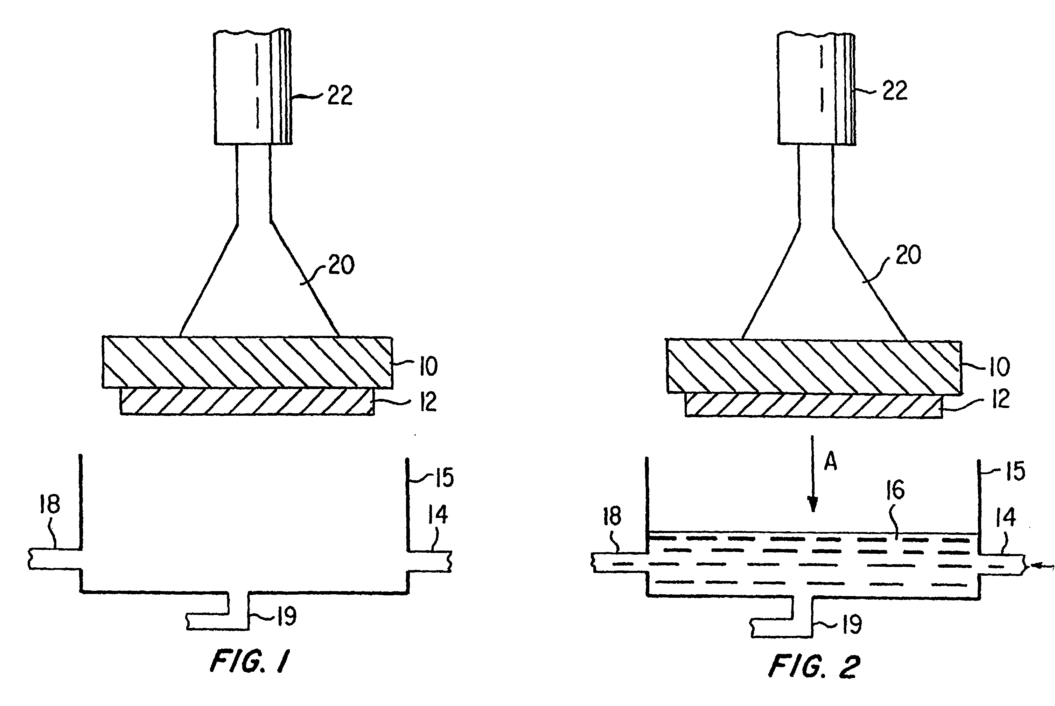

Referring to FIG. 1, chuck 20 is shown holding a substrate 10 such as, for example, a semiconductor wafer. Substrate 10 can be prepared using techniques known to those skilled in the art. The fabrication of semiconductor devices is typically conducted in successive stages, one or more of which can involve the forming of a pattern on the surface by microlithographic techniques. Forming a pattern typically involves coating at least a portion of the substrate 10 with a resist material 12 and then exposing in the appropriate pattern. The resist 12 can then be developed in accordance with the processes described herein. Once the resist 12 is developed, subsequent processing steps, e.g., etching, then can be performed to locally impart the appropriate physical changes in the semiconductor material 10 to yield a desired device structure. Materials suitable for forming and patterning the resist layer 12 as well as developer 16 compositions are known to those skilled in the art. Such conventional materials can be used herein.

The substrate 10 has at least a portion of one surface coated with a resist film or layer 12. The substrate 10 is held by chuck 20. Preferably, chuck 20 is of a size smaller than the size of the substrate 10.

Vessel 15 is configured and dimensioned to receive substrate 10. Vessel 11 can be constructed out of materials presently used to fabricated known or conventional vessels currently used in immersion processes. Developing liquid 16 is introduced via inlet line 14 into vessel 15 as shown in FIG. 2. The amount of developing liquid 16 introduced into the vessel 15 will depend on a number of factors including the size of the substrate 10, the diameter of the vessel 11 and the depth to which the vessel 15 is filled. Typically, for an eight inch wafer, the amount of developing fluid 16 employed will range from about 10 ml to about 400 ml and preferably from about 50 ml to about 200 ml, most preferably from about 100 ml to about 150 ml. The amount of developing liquid 16 introduced into vessel 15 need only provide a pool of fluid at a depth of about 1 mm to about 4 mm in the bottom of vessel 15. The developing liquid 16 is preferably maintained at a uniform temperature in the range from about 15°C to about 50°C, preferably from about 20°C to about 35°C.

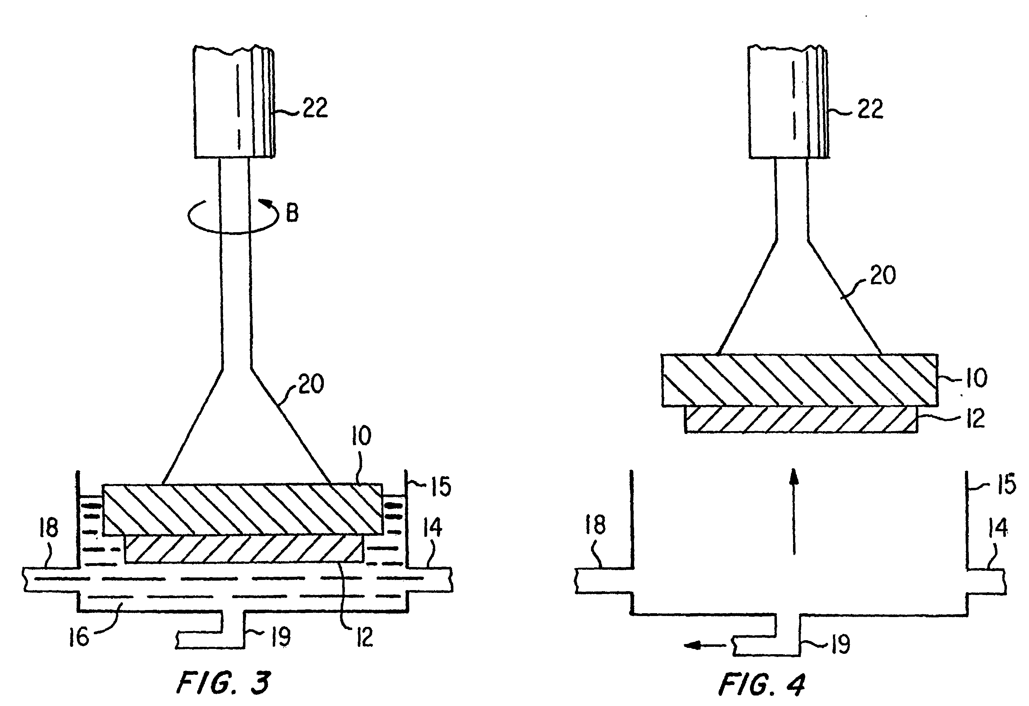

The resist layer 12 is then contacted with the developing liquid 16. In the embodiment illustrated in the figures, chuck 20 is lowered for example by actuating pneumatic cylinder 22 until at least the resist layer 12 is placed into contact with the developing liquid 16 as shown in FIG. 3. It is also contemplated that the vessel 15 can be raised in order to contact the resist layer 12 with the developing fluid 16. In a particularly useful embodiment, the entire substrate 10 is immersed in the developing liquid 16. Chuck 20 is rotatable and wafer 10 held thereby is thus rotated, for example as shown by arrow A in FIG. 3. Chuck 20 can be rotated at speeds in the range of from about 5 to about 2000 rpm, preferably from about 50 rpm to about 200 rpm. The chuck 20 is rotated while resist layer 12 is in contact with the developing liquid 16, to ensure uniformity in the developing process. It should be understood that rotation of chuck 20, and therefore substrate 10, can begin either prior to or after the initial contact of resist layer 12 with the developer 16. Preferably, rotation of chuck 20 continues throughout the contacting step. During the progress of development, the temperature of the developing liquid 16 within vessel 15 should be constantly monitored, for example, by a temperature sensor (not shown) that is immersed therein. Whenever the temperature deviates from a preassigned range, the temperature of liquid 16 can be automatically maintained to the preassigned range by any known or conventional procedure. The temperature of the developing liquid 16 should be under a strict control as practical for the production of precise resist patterns. It is within the purview of one skilled in the art to determine appropriate values for other parameters, such as, for example, normality of the developer 16.

By lowering the rotating substrate 10 and resist layer 12 into the developing liquid 16, the entire surface of the resist layer 12 is simultaneously exposed to the developing liquid 16. This will minimize the effect of non-uniform developing time and, therefore, allow for a uniform developing process. Generally, resist layer 16 will be kept in contact with the developing liquid 16 for a period of time ranging from about 10 seconds to about 150 seconds and preferably from about 20 seconds to about 50 seconds. After the resist layer 12 is contacted with the developing liquid 16 for a desired period of time, piston 22 is again activated and substrate 10 is raised from the developing liquid 16 as shown in FIG. 4. Developing liquid 16 is then withdrawn from vessel 15 via drain line 19, preferably with the assistance of vacuum. It should be understood that in an alternate embodiment contact between the resist layer and the developer can be accomplished simply by draining the developer out of the vessel without moving either the substrate or vessel.

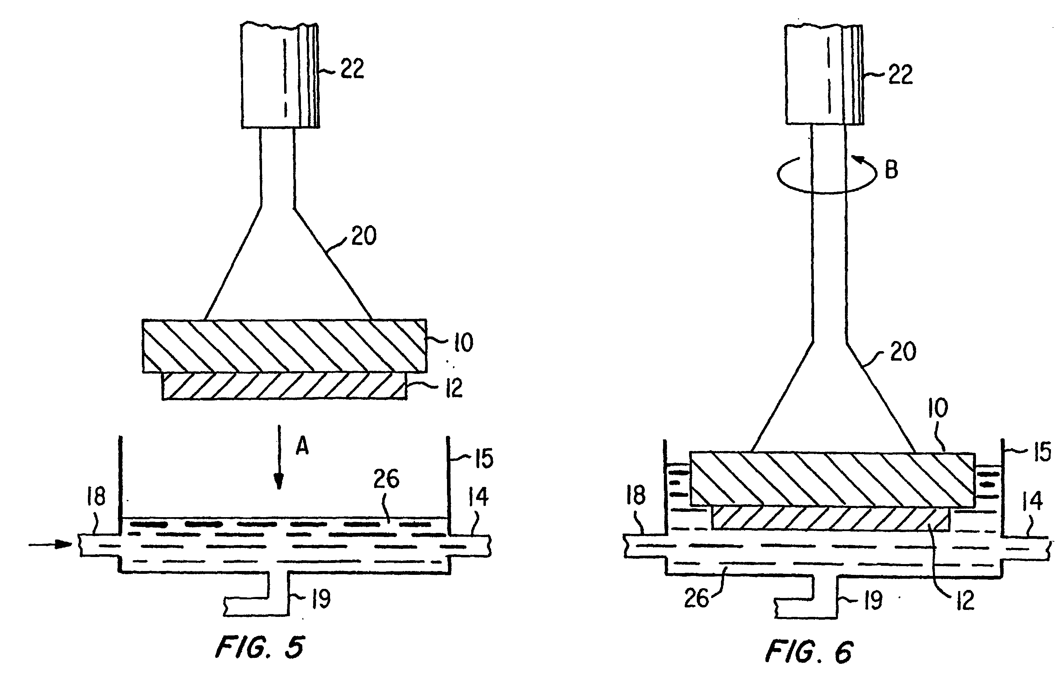

When all of the used developing liquid 16 is withdrawn from the vessel 15, a rinse fluid 26 such as, for example, deionized water is introduced into vessel 15, for example via inlet line 18 (see FIG. 5). Chuck 20 is again lowered such that rotating substrate 10 and developed resist layer 12 are immersed in the rinse fluid 26 to spin clean the developed resist layer 12. The amount of time necessary to spin clean the developed resist layer 12 will generally be in the range of from about 10 seconds to about 150 seconds and preferably from about 20 seconds to about 50 seconds. While not critical, the temperature of the rinse fluid 26 should be kept near the temperature of the developer fluid 16. The process of spin cleaning the developed resist layer 12 may be repeated as necessary, either in a batch or continuous manner.

Following completion of the spin cleaning, chuck 20 is raised from the rinse fluid 26 and the cleaned, developed resist layer 12 may be dried by rotating the substrate 10 at a speed of about 2000 rpm. The substrate 10 is then ready for any subsequent processing. Rinse fluid 26 can be removed from vessel 15 via drain line 19, preferably with assistance of vacuum.

## Claims

1. A method comprising:
a) supporting a substrate (10) adjacent a vessel (15) containing developer (16), the substrate (10) having a resist layer (12) formed on at least a portion thereof;
b) contacting the resist layer (12) with the developer (16) within the vessel (15);
c) rotating the substrate (10) while the resist layer (12) is in contact with the developer (16);
d) replacing the developer (16) within the vessel (15) with a rinse fluid (26);
e) contacting the resist layer (12) with the rinse fluid (26); and
f) rotating the substrate (10) while the resist layer (12) is in contact with the rinse fluid (26).

2. A method as in claim 1 wherein the contacting step comprises moving the substrate (10) from a first position wherein the resist layer (12) is above the developer (16) to a second position wherein the resist layer (12) is in contact with the developer (16).

3. A method as in claim 1 wherein the substrate (10) is rotating prior to the contacting step.

4. A method as in one of the claims 1-3 wherein the replacing step comprises:
separating the resist layer (12) from the developer (16);
draining the developer (16) from the vessel (15); and
adding rinse fluid (26) to the vessel (15).

5. A method as in one of the claims 1-3 wherein the contacting step comprises moving the substrate (10) from a first position wherein the resist layer (12) is located out of contact with the rinse fluid (26) to a second position wherein the resist layer (12) is in contact with the rinse fluid (26).

6. A method as in one of the claims 1-3 wherein the substrate (10) is rotating prior to the contacting step.

7. A method as in one of the claims 1-3 further comprising the steps of separating the resist layer (12) from the rinse fluid (26) and rotating the substrate (10) to remove any residual rinse fluid (26) therefrom.

8. A method for developing a resist layer (12) on a substrate comprising:
lowering the substrate (10) to place the resist layer (12) into contact with developer (16); and
rotating the substrate (10) while the resist layer (12) is in contact with the developer (16).

9. A method as in claim 8 wherein the substrate (10) is rotated prior to the lowering step.

10. A method as in claim 8 wherein the substrate (10) is rotated at a speed of from about 50 to about 200 rpm.

11. A method as in claim 8 wherein the lowering step comprises lowering the substrate (10) into a vessel (15) containing developer (16).

12. A method as in claim 8 further comprising the steps of:
raising the substrate (10) such that the resist layer (12) is out of contact with developer (16); and
rinsing the resist layer (12) with a rinse fluid (26).

13. A method as in claim 12 wherein the rinsing step comprises:
lowering the substrate (10) to place the resist layer (12) into contact with the rinse fluid (26); and
rotating the substrate (10) while the resist layer (12) is in contact with the rinse fluid (26).

14. The process according to claim 8 further comprising the step of maintaining the developer (16) at a temperature from about 20°C to about 35°C.

15. The process according to claim 8 wherein during each rotating step the substrate (10) is rotated at a rotating speed from about 50 rpm to about 200 rpm.

16. The process according to claim 8 wherein the resist layer (12) is contacted with the developer (16) for a time ranging from about 10 seconds to about 150 seconds.

17. An apparatus for developing a resist layer (12) formed over at least a portion of a substrate (10) comprising:
a rotatable substrate holder (20);
a vessel (15) configured and dimensioned to receive a substrate (10) held by the rotatable substrate holder (20);
means for adjusting the relative positions of the rotatable substrate holder (20) and the vessel (15) to a first position wherein a resist layer (12) formed on a substrate (10) held by the rotatable substrate holder (20) is positioned within the vessel (15);
means for rotating the rotatable substrate holder (20) while in the first position;
means for introducing developer (16) into the vessel (15);
means for replacing the developer (16) within the vessel (15) with a rinse fluid (26).

18. An apparatus as in claim 17 wherein the means for adjusting comprises a pneumatic cylinder means to lower the rotatable substrate holder (20) toward the vessel (15).

## Patentansprüche

1. Verfahren, das folgendes umfaßt:
a) Stützen eines Substrats (10) neben einem einen Entwickler (16) enthaltenden Gefäß (15), wobei auf mindestens einem Teil des Substrats (10) eine Resistschicht (12) ausgebildet ist;
b) Kontaktieren der Resistschicht (12) mit dem Entwickler (16) in dem Gefäß (15);
c) Drehen des Substrats (10), während die Resistschicht (12) mit dem Entwickler (16) in Kontakt steht;
d) Ersetzen des Entwicklers (16) im Gefäß (15) durch ein Spülfluid (26);
e) Kontaktieren der Resistschicht (12) mit dem Spülfluid (26) und
f) Drehen des Substrats (10), während die Resistschicht (12) mit dem Spülfluid (26) in Kontakt steht.

2. Verfahren nach Anspruch 1, wobei bei dem Kontaktierungsschritt das Substrat (10) aus einer ersten Position, in der sich die Resistschicht (12) über dem Entwickler (16) befindet, in eine zweite Position bewegt wird, in der die Resistschicht (12) mit dem Entwickler (16) in Kontakt steht.

3. Verfahren nach Anspruch 1, wobei sich das Substrat (10) vor dem Kontaktierungsschritt dreht.

4. Verfahren nach einem der Ansprüche 1 bis 3, wobei bei dem Ersetzungsschritt:
die Resistschicht (12) vom Entwickler (16) getrennt wird,
der Entwickler (16) aus dem Gefäß (15) abgelassen wird und
Spülfluid (26) dem Gefäß (15) zugesetzt wird.

5. Verfahren nach einem der Ansprüche 1-3, wobei bei dem Kontaktierungsschritt das Substrat (10) aus einer ersten Position, in der die Resistschicht (12) nicht in Kontakt mit dem Spülfluid (26) angeordnet ist, in eine zweite Position bewegt wird, in der die Resistschicht (12) mit dem Spülfluid (26) in Kontakt steht.

6. Verfahren nach einem der Ansprüche 1-3, wobei sich das Substrat (10) vor dem Kontaktierungsschritt dreht.

7. Verfahren nach einem der Ansprüche 1-3, weiterhin mit den Schritten des Trennens der Resistschicht (12) von dem Spülfluid (26) und Drehens des Substrats (10), um etwaiges Restspülfluid (26) davon zu entfernen.

8. Verfahren zum Entwickeln einer Resistschicht (12) auf einem Substrat, bei dem:
das Substrat (10) abgesenkt wird, damit die Resistschicht (12) mit dem Entwickler (16) in Kontakt steht, und
das Substrat (10) gedreht wird, während die Resistschicht (12) mit dem Entwickler (16) in Kontakt steht.

9. Verfahren nach Anspruch 8, wobei das Substrat (10) vor dem Absenkschritt gedreht wird.

10. Verfahren nach Anspruch 8, wobei das Substrat (10) mit einer Geschwindigkeit zwischen etwa 50 und etwa 200 UpM gedreht wird.

11. Verfahren nach Anspruch 8, wobei bei dem Absenkschritt das Substrat (10) in ein den Entwickler (16) enthaltendes Gefäß (15) abgesenkt wird.

12. Verfahren nach Anspruch 8, weiterhin mit den folgenden Schritten:
Anheben des Substrats (10) derart, daß die Resistschicht (12) nicht mit dem Entwickler (16) in Kontakt steht, und
Spülen der Resistschicht (12) mit einem Spülfluid (26).

13. Verfahren nach Anspruch 12, wobei bei dem Spülschritt:
das Substrat (10) abgesenkt wird, damit die Resistschicht (12) mit dem Spülfluid (26) in Kontakt kommt, und
das Substrat (10) gedreht wird, während die Resistschicht (12) mit dem Spülfluid (26) in Kontakt steht.

14. Prozeß nach Anspruch 8, weiterhin mit dem Schritt des Haltens des Entwicklers (16) bei einer Temperatur zwischen etwa 20°C und etwa 35°C.

15. Prozeß nach Anspruch 8, wobei das Substrat (10) bei jedem Drehschritt mit einer Drehgeschwindigkeit zwischen etwa 50 UpM und etwa 200 UpM gedreht wird.

16. Prozeß nach Anspruch 8, wobei die Resistschicht (12) über einen von etwa 10 Sekunden bis etwa 150 Sekunden dauernden Zeitraum mit dem Entwickler (16) kontaktiert wird.

17. Vorrichtung zum Entwickeln einer Resistschicht (12), die über mindestens einem Teil eines Substrats (10) ausgebildet ist, umfassend:
eine drehbare Substrathalterung (20);
ein Gefäß (15), das so konfiguriert und bemessen ist, daß es ein von der drehbaren Substrathalterung (20) gehaltenes Substrat aufnimmt;
ein Mittel zum Einstellen der relativen Positionen der drehbaren Substrathalterung (20) und des Gefäßes (15) in eine erste Position, bei der eine Resistschicht (12), die auf einem von der drehbaren Substrathalterung (20) gehaltenen Substrat (10) ausgebildet ist, im Gefäß (15) positioniert ist;
ein Mittel zum Drehen der drehbaren Substrathalterung (20), wenn sie sich in der ersten Position befindet;
ein Mittel zum Einleiten des Entwicklers (16) in das Gefäß (15);
ein Mittel zum Ersetzen des Entwicklers (16) im Gefäß (15) durch ein Spülfluid (26).

18. Vorrichtung nach Anspruch 17, bei der das Mittel zum Einstellen ein pneumatisches Zylindermittel zum Absenken der drehbaren Substrathalterung (20) in Richtung auf das Gefäß (15) umfaßt.

## Revendications

1. Procédé selon lequel :
a) on tient un support (10) au voisinage d'un récipient (15) contenant un révélateur (16), le support (10) ayant une couche de résist (12) formé sur au moins une partie de celui-ci ;
b) on met en contact la couche de résist (12) avec le révélateur (16) de la cuve (15) ;
c) on fait tourner le support (10) pendant que la couche de résist (12) est en contact avec le révélateur (16);
d) on remplace le révélateur (16) de la cuve (15) par un liquide de rinçage (26) ;
e) on met en contact la couche de résist (12) avec le liquide de rinçage (26) ; et
f) on fait tourner le support (10) pendant que la couche de résist (12) est en contact avec le liquide de rinçage (26).

2. Procédé selon la revendication 1,
**caractérisé en ce que**
l'étape de mise en contact consiste à déplacer le support (10) d'une première position dans laquelle la couche de résist (12) se trouve au-dessus du révélateur (16) dans une seconde position dans laquelle la couche de résist (12) est en contact avec le révélateur (16).

3. Procédé selon la revendication 1,
**caractérisé en ce que**
le support (10) tourne avant l'étape de mise en contact.

4. Procédé selon l'une des revendications 1 à 3,
**caractérisé en ce que**
l'étape de remplacement consiste à séparer la couche de résist (12) du révélateur (16) ;
à extraire le révélateur (16) de la cuve ; et
à ajouter du liquide de rinçage (26) au récipient (15).

5. Procédé selon l'une des revendications 1 à 3,
**caractérisé en ce que**
l'étape de mise en contact consiste à déplacer le support (10) d'une première position dans laquelle la couche de résist (12) est hors contact du liquide de rinçage (26) jusque dans une seconde position dans laquelle la couche de résist (12) est en contact avec le liquide de rinçage (26).

6. Procédé selon l'une des revendications 1 à 3,
**caractérisé en ce que**
le support (10) tourne avant l'étape de mise en contact.

7. Procédé selon l'une des revendications 1 à 3,
**caractérisé par en outre**
les étapes de séparation de la couche de résist (12) du liquide de rinçage (26) et de mise en rotation du support (10) pour enlever tout liquide de rinçage résiduel (26).

8. Procédé pour développer une couche de résist (12) d'un support, consistant à :
- abaisser le support (10) pour mettre la couche de résist (12) en contact avec le révélateur 16) ; et
- faire tourner le support (10) pendant que la couche de résist (12) est en contact avec le révélateur (16).

9. Procédé selon la revendication 8,
**caractérisé en ce que**
le support (10) tourne avant l'étape d'abaissement.

10. Procédé selon la revendication 8,
**caractérisé en ce que**
le support (10) est mis en rotation à une vitesse de l'ordre de 50 à 200 t/min.

11. Procédé selon la revendication 8,
**caractérisé en ce que**
l'étape d'abaissement consiste à abaisser le support (10) dans la cuve (15) contenant le révélateur (16).

12. Procédé selon la revendication 8,
**caractérisé en outre par** les étapes suivantes :
- on tient le support (10) de façon que la couche de résist (12) soit hors de contact du développeur (16) ; et
- on rince la couche de résist (12) avec du liquide de rinçage (26).

13. Procédé selon la revendication 12,
**caractérisé en ce que**
l'étape de rinçage consiste à :
- abaisser le support (10) pour mettre la couche de résist (12) en contact avec le liquide de rinçage (26) ; et
- à faire tourner le substrat (10) pendant que la couche de résist (12) est en contact avec le liquide de rinçage (26).

14. Procédé selon la revendication 8,
**caractérisé par**
une étape consistant à maintenir le révélateur (16) à une température de l'ordre d'environ 20°C jusqu'à environ 35°C.

15. Procédé selon la revendication 8,
**caractérisé en ce que**
dans chaque étape de mise en rotation, le support 10) tourne à une vitesse de rotation d'environ 50 t/min jusqu'à environ 200 t/min.

16. Procédé selon la revendication 8,
**caractérisé en ce que**
la couche de résist (12) est mise en contact avec le révélateur (16) pendant une durée allant d'environ 10 secondes à environ 150 secondes.

17. Appareil pour développer une couche de résist (12) formé sur au moins une partie d'un support (10) comprenant :
- un dispositif de maintien de support (20), rotatif ;
- une cuve (15) de forme et de dimension permettant de recevoir un support (10) tenu par le dispositif de maintien (20), rotatif ;
- un moyen pour régler la position relative du dispositif de maintien de support (20), rotatif et la cuve (15) dans une première position dans laquelle une couche de résist (10) formée sur un substrat (10) est tenue par le support de substrat (20), rotatif, qui est positionné dans le récipient (15) ;
- un moyen pour faire tourner le dispositif de maintien rotatif du substrat (20) dans une première position ;
- un moyen pour introduire un révélateur (16) dans la cuve (15);
- un moyen pour remplacer le révélateur (16) de la cuve (15) par un liquide de rinçage (26).

18. Appareil selon la revendication 17,
**caractérisé en ce que**
le moyen de réglage comprend un vérin pneumatique pour abaisser le dispositif de maintien rotatif (20) du support en direction du récipient (15).
